# EUROPEAN PATENT APPLICATION

(11) **EP 2 472 628 A1**
(43) Date of publication of application: **04.07.2012**
(21) Application number: 10811803.5
(22) Date of filing: 23.08.2010
(51) Int. Cl.: H01L 51/50, H05B 33/10

(54) **ORGANIC ELECTROLUMINESCENT ELEMENT**

(30) Priority: 25.08.2009 JP 2009193915
(71) Applicant: Sumitomo Chemical Company, Limited, Tokyo 104-8260 (JP)
(72) Inventor: YAMAMOTO Kyoko, Tsukuba-shi Ibaraki 305-0817 (JP)
(74) Representative: Jackson, Martin Peter
(86) International application number: PCT/JP2010/064173
(87) International publication number: WO 2011/024753

(57) **Abstract**

The present invention provides an organic EL element configured to stably emit light while suppressing total reflection that occurs at an electrode. This organic EL element includes a pair of electrodes and one or more organic layers provided between the electrodes, and includes a light-emitting layer as the one or more organic layers. Surfaces of the pair of electrodes facing each other are flat. At least one organic layer of the one or more organic layers has a periodic structure that makes the traveling direction of light, traveling in the direction generally perpendicular to the thickness direction of the light-emitting layer, inclined to the thickness direction. The periodic structure has a periodic configuration that is arranged with a two-dimensional period in a plane that is perpendicular to the thickness direction of the light-emitting layer.

## Description

### Technical Field

The present invention relates to an organic electroluminescent element (hereinafter, also referred to as an organic EL element), a display device and a lighting device including this element, and a production method of the organic EL element.

### Background Art

An organic electroluminescent element includes a pair of electrodes (an anode and a cathode) and a light-emitting layer interposed between the electrodes. In the organic EL element, when holes are injected from the anode and electrons are injected from the cathode by applying a voltage between the pair of electrodes, the holes and the electrons combine to emit light in the light-emitting layer.

At least one of the pair of electrodes is structured with a member having optical transparency, and light generated at the light-emitting layer exits through the electrode having optical transparency. Currently, for the electrode having optical transparency, an indium tin oxide (ITO) thin film is commonly used.

Because the refractive index of the ITO thin film is higher than that of the light-emitting layer, total reflection of light occurs at the boundary face of the ITO thin film. Accordingly, large portion of the light emitted from the light-emitting layer is confined within the element without exiting, and thus is not effectively used currently. In view of this, proposed has been an organic EL element in which, by forming a diffraction grating that changes the traveling direction of light emitted from the light-emitting layer between the electrodes, the incident angle of light into an electrode (an ITO thin film) is reduced so that total reflection at the electrode is avoided (see Patent Literature 1, for example).

### Citation List

### Patent Literature

[Patent Literature 1] Japanese Patent Application Laid-Open No. 2006-269294.

### Summary of Invention

### Technical Problem

An organic EL element of the conventional art has periodic projections and depressions on an electrode and further has a light-emitting layer on the electrode, thereby forming a periodic structure that functions as a diffraction grating at the boundary face between the electrode and the light-emitting layer. The organic EL element including the electrode on the surface of which periodic projections and depressions are formed, in which there is a variation in the distance between a pair of electrodes and accordingly there is a variation in the strength of an electric field between the pair of electrodes, problematically cannot provide stable light emission.

Therefore, an object of the present invention is to provide an organic EL element that is configured to stably emit light while suppressing total reflection that occurs at an electrode.

### Solution to Problem

The present invention relates to an organic electroluminescent element that includes a pair of electrodes and one or more organic layers provided between the electrodes, and includes a light-emitting layer as the one or more organic layers, wherein
surfaces of the pair of electrodes facing each other are flat,
at least one organic layer of the one or more organic layers has a periodic structure that makes the traveling direction of light, traveling in the direction generally perpendicular to the thickness direction of the light-emitting layer, inclined to the thickness direction, and
the periodic structure has a periodic configuration that is arranged with a two-dimensional period in a plane that is perpendicular to the thickness direction of the light-emitting layer.
In addition, the present invention relates to the organic electroluminescent element, wherein both main surfaces of the light-emitting layer are flat and plane.
In addition, the present invention relates to the organic electroluminescent element, wherein an organic layer that is arranged in contact with one of the main surfaces of the light-emitting layer out of the one or more organic layers has the periodic structure, and voids are formed in the organic layer having the periodic structure.
In addition, the present invention relates to the organic electroluminescent element, wherein the light-emitting layer has the periodic structure.
In addition, the present invention relates to a display device that includes the organic electroluminescent element.
In addition, the present invention relates to a lighting device that includes the organic electroluminescent element.
In addition, the present invention relates to a production method of an organic electroluminescent element that includes a pair of electrodes and one or more organic layers provided between the electrodes and includes a light-emitting layer as the one or more organic layers, the production method including:
a step of forming one of the pair of electrodes;
a step of forming one or more organic layers; and
a step of forming the other one of the pair of electrodes, wherein
in the step of forming one or more organic layers, by forming a plane layer as the organic layer and further forming a periodic configuration arranged with a two-dimensional period in a plane that is perpendicular to the thickness direction of the light-emitting layer on the plane layer, a periodic structure is formed that makes the traveling direction of light, traveling in the direction generally perpendicular to the thickness direction of the light-emitting layer, inclined to the thickness direction.
In addition, the present invention relates to the production method of an organic electroluminescent element, wherein the method of forming a two-dimensional periodic structure on the plane layer is an imprint method.
In addition, the present invention relates to the production method of an organic electroluminescent element, wherein the method of forming a two-dimensional periodic structure on the plane layer is a photolithography method.

### Advantageous Effects of Invention

According to the present invention, it is possible to provide an organic EL element configured to stably emit light while suppressing total reflection that occurs at an electrode.

### Brief Description of Drawings

[FIG. 1] FIG. 1 is a diagram schematically illustrating an organic EL element.
[FIG. 2] FIG. 2 schematically illustrates arrangement in which depressions 7 are provided.
[FIG. 3] FIG. 3 is a diagram schematically illustrating the organic EL element.
[FIG. 4] FIG. 4 is a longitudinal cross-sectional view of the organic EL element.
[FIG. 5] FIG. 5 is a longitudinal cross-sectional view of the organic EL element.
[FIG. 6] FIG. 6 is a longitudinal cross-sectional view of the organic EL element.
[FIG. 7] FIG. 7 is a partial longitudinal cross-sectional view of the organic EL element.
[FIG. 8] FIG. 8 is a partial longitudinal cross-sectional view of the organic EL element.
[FIG. 9] FIG. 9 is a longitudinal cross-sectional view of the organic EL element.
[FIG. 10] FIG. 10 is a longitudinal cross-sectional view of the organic EL element.
[FIG. 11] FIG. 11 is a plan view of an intermediate of the organic EL element.
[FIG. 12] FIG. 12 is a longitudinal cross-sectional view of the organic EL element.
[FIG. 13] FIG. 13 is a diagram illustrating a display device that includes the organic EL element.
[FIG. 14] FIG. 14 is a diagram illustrating an illuminating device that includes the organic EL element.

### Description of Embodiments

An organic EL element of the present invention includes a pair of electrodes and one or more organic layers provided between the electrodes, and is configured to include a light-emitting layer as the one or more organic layers, wherein surfaces of the pair of electrodes facing each other are flat, at least one organic layer of the one or more organic layers has a periodic structure that makes the traveling direction of light, which travels in the direction generally perpendicular to the thickness direction of the light-emitting layer, inclined to the thickness direction, and the periodic structure is arranged with a two-dimensional period in a plane that is perpendicular to the thickness direction of the light-emitting layer.

The organic EL element is generally formed by being provided on a substrate and laminating a pair of electrodes and one or more organic layers one by one.

The pair of electrodes differ from each other in polarity, and each is provided as an anode or a cathode. Between the pair of electrodes, one or more organic layers are provided. The organic EL element includes a light-emitting layer as the at least one layer of the one or more organic layers. In other words, the at least one light-emitting layer is provided between the pair of electrodes. It should be noted that a predetermined organic layer other than the light-emitting layer may be provided between the pair of electrodes, and also two or more light-emitting layers may be provided between the pair of electrodes. Furthermore, between the pair of electrodes, an inorganic layer consisting of inorganic substances and a mixed layer including organic substances and inorganic substances may be provided.

### (1) Structure of an organic EL element

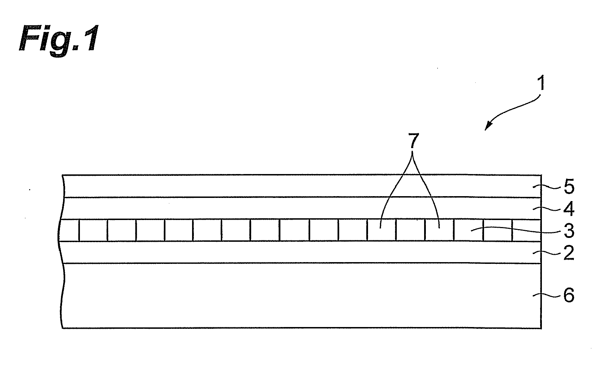

Referring to FIG. 1, an organic EL element 1 according to one embodiment of the present invention will be described hereinafter. FIG. 1 is a diagram schematically illustrating the organic EL element of the present embodiment. FIG. 1, as one example of the embodiment, illustrates the organic EL element 1 structured such that one electrode 2, a hole injection layer 3, a light-emitting layer 4, and the other electrode 5 are laminated on a supporting substrate 6 in this order.

At least one out of the one electrode 2 and the other electrode 5 is configured with an electrode having optical transparency. Another electrode different from this electrode having optical transparency may be an electrode having optical transparency or may be an opaque electrode, and is preferable to be configured with a reflective electrode that reflects light toward the electrode having optical transparency.

In a so-called bottom emission type organic EL element in the structure of which light emitted from the light-emitting layer 4 exits through the supporting substrate 6, the electrode 2 on the lower side is composed of optically transparent material, and a substrate having optical transparency is used for the supporting substrate 6. It should be noted that, in the case of a top emission type organic EL element in the structure of which light emitted from the light-emitting layer 4 exits through the other electrode 5, the electrode 5 on the upper side is composed of optically transparent material, but the supporting substrate 6 may be a substrate having optical transparency or may be an opaque substrate.

The one electrode 2 is provided on the supporting substrate 6. Both main surfaces of this one electrode 2 are flat and plane. In other words, on the surfaces of the one electrode 2, projections and depressions are not formed. In the bottom emission type organic EL element described above, an electrode having optical transparency is used for the one electrode 2. In addition, in the top emission type organic EL element, it is preferable to use a reflective electrode that reflects light toward the other electrode 5 for the one electrode 2.

In the present embodiment, the one electrode 2 is provided as an anode. It should be noted that, described will be the organic EL element in the structure of which the electrode functioning as an anode out of the pair of electrodes is arranged nearer the supporting substrate 6 and the electrode 5 functioning as a cathode is arranged in the position separate from the supporting substrate 6, but conversely it is acceptable that the organic EL element has the structure in which the electrode functioning as a cathode out of the pair of electrodes is arranged nearer the supporting substrate and the electrode functioning as an anode is arranged in the position separate from the supporting substrate.

In the present embodiment, the hole injection layer is provided as one layer of the one or more organic layers, and this hole injection layer has the periodic structure. In other words, the hole injection layer has the two-dimensional periodic structure that makes the traveling direction of light, which travels in the direction generally perpendicular to the thickness direction of the light-emitting layer, inclined to the thickness direction.

In the present embodiment, as the periodic structure arranged with a two-dimensional period, a plurality of depressions 7 extending in the thickness direction of the hole injection layer is formed on the hole injection layer, and these depressions 7 are formed with a two-dimensional predetermined period in a plane perpendicular to the thickness direction of the hole injection layer.

The depressions 7 may pass through the hole injection layer 3, or do not have to pass through it. When the depressions 7 do not pass through the hole injection layer 3, the depressions 7 may extend in the hole injection layer 3 from the main surface on the side of the light-emitting layer toward the side of the one electrode 2, or may extend through the hole injection layer 3 from the main surface on the side of the one electrode 2 toward the side of the light-emitting layer. It should be noted that FIG. 1 schematically illustrates the depressions 7 passing through the hole injection layer 3 in the thickness direction thereof.

Examples of a shape determined by the surface facing the depressions 7 (i.e., an inner shape of the depressions 7) include a cylinder, a polygonal column, a cone, a polygonal pyramid, a truncated cone, a truncated pyramid. A shape of the inner surface of the depressions 7 may be a cylindrical surface, a polygonal column surface, a conical surface, a polygonal pyramid surface, a truncated conical surface, a truncated pyramid surface, or the like.

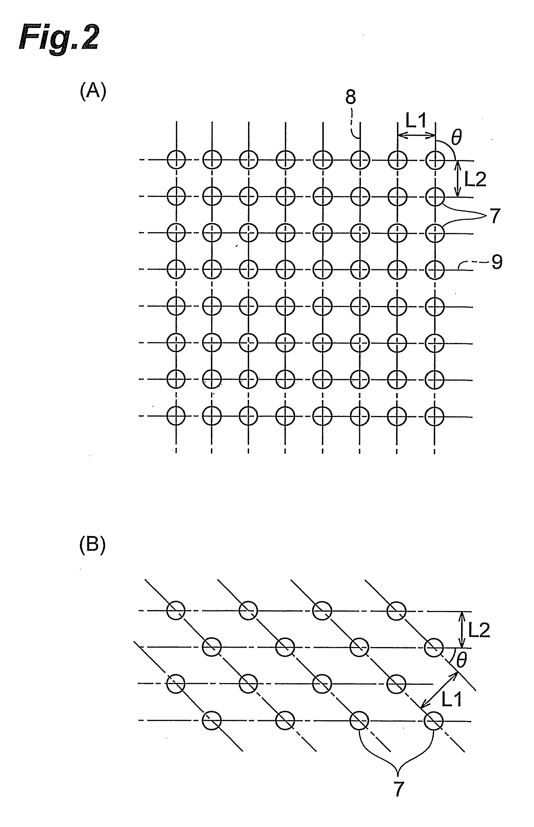

FIG. 2 schematically illustrates arrangement in which the depressions 7 are provided. FIG. 2 is a diagram of the hole injection layer 3 viewed from one side of the thickness direction thereof. A cylindrical shape is assumed as a shape of the depressions 7, and circles are depicted as cross-sectional shapes of the depressions 7. It should be noted that it is preferable that the depressions 7 be formed over the entire area in which the pair of electrodes face each other.

For example, the depressions 7 are arranged at the points of intersection of a plurality of first stripes that are parallel to each other at equal intervals to each other (hereinafter, referred to as vertical stripes 8) and second stripes that are not parallel to the first stripes (hereinafter, referred to as horizontal stripes 9). FIG. 2 indicates the vertical stripes 8 and the horizontal stripes 9 with two-dot chain lines. The crossing angle θ between the vertical stripes 8 and the horizontal stripes 9 may be any angle, and an interval L1 between the vertical stripes 8 and an interval L2 between the horizontal stripes 9 may be the same or may be different.

FIG. 2(A) illustrates arrangement of the depressions 7 for the case in which the crossing angle θ between the vertical stripes 8 and the horizontal stripes 9 is 90° and the interval L1 between the vertical stripes 8 and the interval L2 between the horizontal stripes 9 are the same. FIG. 2(B) illustrates arrangement of the depressions 7 in the case that the crossing angle θ between the vertical stripes 8 and the horizontal stripes 9 is 45° and the interval L1 between the vertical stripes 8 is "2^{1/2}" when the interval L2 between the horizontal stripes 9 is "1". Furthermore, for example, the depressions 7 may be arranged at the points of intersection of the vertical stripes 8 and the horizontal stripes 9 in the case that the crossing angle θ between the vertical stripes 8 and the horizontal stripes 9 is 60° (acute angle) and the interval L1 between the vertical stripes 8 and the interval L2 between the horizontal stripes 9 are the same.

Each of the interval L1 between the vertical stripes 8 and the interval L2 between the horizontal stripes 9 and also the crossing angle θ between the vertical stripes 8 and the horizontal stripes 9 is set to configure a diffraction grating that changes the traveling direction of light so as to make the traveling direction of light, which travels in the direction generally perpendicular to the thickness direction of the hole injection layer 3, inclined to the thickness direction of the hole injection layer 3. For example, the interval L1 between the vertical stripes 8 and the interval L2 between the horizontal stripes 9 are generally from the order of distance (λo/n) that is one wavelength (λo) in a vacuum of light to be used as outgoing light out of light emitted from the light-emitting layer divided by the refractive index (n) to the order of several times the distance (λo/n), and is preferable to be on the order of distance (λo/n) that is one wavelength (λo) in a vacuum of light to be used as outgoing light divided by the refractive index (n). It should be noted that the refractive index is a refractive index of a member having a periodic structure (the hole injection layer 3 in the present invention) and is a refractive index at the wavelength (λo) of light to be used as outgoing light. This refractive index, for a member composed of organic substances, is generally on the order of 1.7. In the case that the wavelength λo of light generated in the light-emitting layer is that of visible light being in the wavelength range of 380 nanometers to 780 nanometers, it is possible to set the refractive index n=1.7 and, in the case of the crossing angle θ=90°, to set L1=L2=λo/n=224 nanometers to 458 nanometers.

The height (depth) of the depressions 7 in the thickness direction of the hole injection layer is preferable to have a height enough to be able to diffract light and, for example, it is 20 nanometers to 1 micrometer, is preferably 30 nanometers to 500 micrometers, and is more preferably 40 nanometers to 300 micrometers.

In addition, the width of the depressions 7 in the direction perpendicular to the thickness direction of the hole injection layer is equal to or smaller than half the above-described interval L1 between the vertical stripes 8 or the interval L2 between the horizontal stripes 9, is preferably 80 nanometers to 500 nanometers, and is more preferably 100 to 300 nanometers.

The light-emitting layer 4, as in the embodiment described later, may be formed with a portion thereof being charged into the depressions 7 formed on the hole injection layer, but in the present embodiment, the light-emitting layer 4, both main surfaces of which are flat and plane, is formed on the hole injection layer 3.

It is preferable that the organic layer arranged in contact with one main surface of the light-emitting layer out of the one or more organic layers have the periodic structure and voids be formed in the organic layer having the periodic structure, and in the present embodiment, the hole injection layer corresponds to the organic layer that is in contact with the light-emitting layer, both main surfaces of which are flat and plane, and has the periodic structure. As described above, the depressions 7 are formed on the hole injection layer 3, and with the plane light-emitting layer 4 being formed on the hole injection layer 3, the periodic voids are formed on the hole injection layer 3. In other words, any part of the light-emitting layer, for example, is not charged into the depressions 7, and voids into which gas such as air is charged are formed in the depressions 7.

The other electrode 5 is formed on the light-emitting layer 4. In the present embodiment, the other electrode 5 is provided as a cathode. It should be noted that, in the bottom emission type organic EL element described above, for the other electrode 5, it is preferable to use a reflective electrode that reflects light to the one electrode 2. In addition, in the top emission type organic EL element, for the other electrode 5, an electrode having optical transparency is used.

In the organic EL element 1 of the present embodiment described above, as the at least one organic layer out of the one or more organic layers, the hole injection layer 3 has a two-dimensional periodic structure. Because such a periodic structure is formed on the hole injection layer 3, it is possible to make the traveling direction of light that is traveling with an angle at the electrode (light whose incident angle into the electrode is larger than the critical angle, such as light whose incident angle into the electrode is close to 90°) inclined to the direction perpendicular to the electrode (the normal direction to the surface of the electrode). Accordingly, it is possible to suppress total reflection that occurs at the electrode and efficiently emit light, which would be confined within the element and would not exit if the periodic structure were not formed, out of the element.

In addition, in the pair of electrodes, the surfaces of both electrodes facing each other are flat. If the surfaces of the pair of electrodes facing each other had asperities, variations in the distance between the pair of electrodes might arise and have an influence on the strength of an electric field generated between the pair of electrodes, and thus it might be impossible to obtain an organic EL element that stably emits light, but in the present embodiment, by forming the periodic structure only on the organic layer without forming a periodic structure on the electrodes, it is possible to make the surfaces of both electrodes facing each other flat and keep the distance between the pair of electrodes constant. Accordingly, it is possible to obtain an organic EL element that stably emits light.

In addition, in the present embodiment, both main surfaces of the light-emitting layer are flat and plane. If the light-emitting layer has asperities, unevenness in light emission might arise, but by evenly forming the light-emitting layer, it is possible to obtain uniform light emission.

In addition, the organic layer (the hole injection layer 3 in the present embodiment) that is arranged in contact with the one main surface of the light-emitting layer out of the one or more organic layers has a periodic structure, and voids are formed on the organic layer (the hole injection layer 3 in the present embodiment) having this periodic structure. Because the refractive index of the light-emitting layer and that of the hole injection layer are close, in the diffraction grating with a structure in which part of the light-emitting layer is charged into the depressions 7 formed on the hole injection layer, the effect of diffraction is small, but by forming voids of air in the depressions 7 of the hole injection layer, it is possible to make large the difference in refractive index between the hole injection layer and the inside of the depressions 7, making it possible to make full use of the function as a diffraction grating.

In the present embodiment, the hole injection layer is arranged in the area except the depressions 7, but conversely it is acceptable to form the hole injection layer in the area where the depressions 7 is formed in the present embodiment and provide voids in the area where the hole injection layer is formed in the present embodiment. Even a periodic structure with such a configuration demonstrates a function as a diffraction grating. It should be noted that, in this case, for example, a plurality of cylindrical hole injection layers are formed, but the configuration of the present embodiment in which the hole injection layer is formed in the area except the depressions 7 is more preferable because the mechanical strength thereof is higher.

In addition, in the present embodiment, the depressions 7 formed on the hole injection layer are set to be voids, but it is acceptable to charge material whose refractive index differs from that of the hole injection layer into the depressions 7 and further provide a flat light-emitting layer thereon.

### (2) Production method of the organic EL element

Hereinafter, along with the description of a production method of the organic EL element of the present embodiment depicted in FIG. 1, the production method of the organic EL element of the present invention will be described.

The production method of the organic EL element of the present invention includes a step of forming one electrode of a pair of electrodes, a step of forming one or more organic layers, and a step of forming the other electrode of the pair of electrodes.

### <Step of Forming One Electrode>

To begin with, prepare the supporting substrate 6 described later, and form the one electrode on this supporting substrate 6 by a predetermined method described later.

### <Formation of One or More Organic Layers>

In the present embodiment, as one of the one or more organic layers, form the hole injection layer first.

To begin with, form a plane layer to be the organic layer (the hole injection layer in the present embodiment). It is possible to form the plane layer by, for example, applying ink containing material to be the plane layer by a predetermined coating method and further drying it. For example, by applying ink containing material to be the hole injection layer described later by the predetermined coating method and further drying it, it is possible to form the plane layer.

Next, form the periodic structure on the organic layer by processing the plane layer. More specifically, by forming on the plane layer the periodic structure arranged two-dimensionally and periodically in a plane perpendicular to the thickness direction of the light-emitting layer (the thickness direction of the supporting substrate 6), form the periodic structure that makes the traveling direction of light, which travels in the direction generally perpendicular to the thickness direction of the light-emitting layer, inclined to the thickness direction on the organic layer (the hole injection layer in the present embodiment).

Examples of a method of forming the periodic structure on the plane layer include an imprint method (a so-called embossing method), a photolithography method, a method of scraping a surface of the plane layer with a member having roughness, a method of forming a projections-and-depressions structure by using self-organization, and among these, the imprint method or the photolithography method capable of forming a desired periodic structure with high accuracy is preferable.

In the imprint method, by pressing a predetermined mold on the surface of which periodic projections are formed onto the plane layer, it is possible to form the periodic depressions 7 on the plane layer. For example, as the predetermined mold, one on which projections are periodically formed could be used. Such a mold can be obtained by, for example, using an electron beam lithography system on the surface area of a silicon substrate to form predetermined projections and depressions. It should be noted that when forming the periodic structure by the imprint method, the plane layer could be dried such that its viscosity increases to the extent that the shape of the mold can be transferred.

Alternatively, in the photolithography method, for example, by applying a photoresist to the plane layer first, and radiate light onto a predetermined part to cure the predetermined part of the photoresist, and further develop it, form on the plane layer a mask with holes formed in the part where the depressions 7 should be formed. Furthermore, by dry etching or wet etching, it is possible to selectively remove the plane layer from portions where the holes of the mask open to form the depressions 7 in the predetermined part. It should be noted that when forming the depressions 7 by the photolithography method, in a step of forming the photoresist or removing the photoresist, a predetermined material could be added to the hole injection layer so that the hole injection layer does not dissolve.

Alternatively, without using the mask using the photoresist, it is possible to form the depressions 7 in the predetermined part by the photolithography method. For example, by adding a predetermined material in advance to form the plane layer whose solubility in etchant varies depending on the presence of light radiation, and then selectively radiating light onto the plane layer via a predetermined mask, and further using a predetermined etchant to selectively remove the plane layer, it is possible to form the depressions 7 in the predetermined part. More specifically, by adding a silane coupling agent to poly(3,4-ethylenedioxythiophene)/polystyrenesulfonic acid (PEDOT/PSS) that is material of the hole injection layer to form the plane layer exhibiting insolubility in water, alcohol, and other solutions, and further radiating light onto the predetermined part via the predetermined mask to solubilize the part irradiated with light in water, alcohol, and other solutions, and then using water as an etchant to remove the part irradiated with light, it is possible to form the depressions 7 in the predetermined part. Such a forming method of depressions themselves is a widely well-known method, and is disclosed in Japanese Patent Application Laid-Open Publication No. 2008-98104, for example.

Next, form the light-emitting layer. Because both main surfaces of the light-emitting layer of the present embodiment are flat and plane as described above, the light-emitting layer is formed by a lamination method, for example. For example, by forming a light-emitting layer on a highly releasable substrate in advance and further transferring it, it is possible to form the light-emitting layer on the hole injection layer. It should be noted that it is preferable to transfer the light-emitting layer to the hole injection layer under the condition in which the contacting surfaces between the light-emitting layer and the hole injection layer are wet with a predetermined solvent. In this manner, under the condition in which at least one of the surfaces of light-emitting layer and the hole injection layer is wet, by laminating the both layers, it is possible to secure the bonding of the both. The lamination method is a widely well-known method. The lamination method is disclosed in Appl. Phys. Lett. Volume 88, Issue 22, p. 223509 (2006), for example, and it is possible to use such a method.

### <Step of Forming the Other Electrode>

Next, form the other electrode on the light-emitting layer by a predetermined method.

As described above, in the present embodiment, by directly processing the hole injection layer, it is possible to form the periodic structure on the hole injection layer. In conventional techniques, because a periodic structure is formed by processing a supporting substrate or an electrode, an electrode the surface of which has projections and depressions is formed, but by processing the hole injection layer as in the present embodiment, it is possible to form the diffraction grating within the organic EL element while keeping the flatness of the electrode. Accordingly, it is possible to fabricate the organic EL element configured to stably emit light while suppressing total reflection that occurs at an electrode.

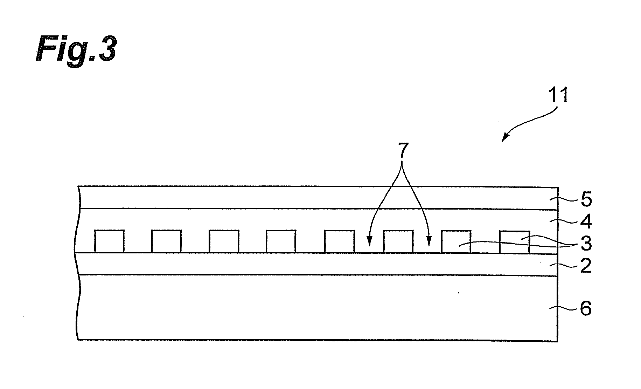

Hereinafter, referring to FIG. 3, an organic EL element according to an embodiment that differs from that of the above-described embodiment will be described. FIG. 3 is a diagram schematically illustrating this organic EL element 11 of the present embodiment.

Because the organic EL element 11 of the present embodiment differs from the above-described organic EL element only in the structure of the light-emitting layer, only the light-emitting layer will be described in the present embodiment, and corresponding parts are denoted by the same reference numerals and overlapping descriptions are omitted.

In the present embodiment, in addition to the hole injection layer, the light-emitting layer has a periodic structure. In other words, both main surfaces of the light-emitting layer are not flat or plane. More specifically, the light-emitting layer of the present embodiment, part of which is charged into the depressions 7 formed on the hole injection layer, is formed on the hole injection layer. In other words, in the light-emitting layer, projections corresponding to the depressions 7 on the hole injection layer described above are formed on the surface on the side of the one electrode. In addition, the surface of the light-emitting layer on the side of the other electrode 5 is flat. Part of the light-emitting layer is charged into the depressions 7 formed on the hole injection layer, making it possible to avoid formation of voids. Accordingly, it is possible to enhance the mechanical strength of the organic EL element. It should be noted that in order for the periodic structure to effectively demonstrate a function as a diffraction grating, it is preferable to form the hole injection layer and the light-emitting layer out of materials having large difference in refractive index.

It is possible to form the light-emitting layer by a vapor deposition method or a coating method, for example. For example, in the coating method, by applying ink containing material to be the light-emitting layer on the hole injection layer by a predetermined coating method and curing it, the light-emitting layer is formed. When applying ink, the ink flows into the inside of the depressions 7 on the hole injection layer, and thus the light-emitting layer is formed also inside the depressions 7 of the hole injection layer. Alternatively, by the vapor deposition, the light-emitting layer is formed inside the depressions 7 of the hole injection layer.

In the organic EL elements of the respective embodiments described above, a sealing material that seals the organic EL element is further provided. It should be noted that in the embodiment depicted in FIG. 1, only the light-emitting layer is transferred by the lamination method, but it is acceptable, for example, to form the other electrode 5 and the light-emitting layer 4 in this order on the sealing material in advance, and transfer the sealing material on which the other electrode 5 and the light-emitting layer 4 are formed onto the hole injection layer 3.

To further improve the light extracting efficiency of the organic EL elements of the respective embodiments described above, it is preferable to form projections and depressions on a plane from which light exits (i.e., the boundary face to the air), for example. In a bottom emission type organic EL element, it is preferable to form projections and depressions on the surface of the supporting substrate 6, and in a top emission type organic EL element, it is preferable to form projections and depressions on the surface of the sealing material.

As projections and depressions, it is preferable to form projections and depressions whose difference in height is equal to or larger than 0.1 micrometer and equal to or smaller than 0.2 millimeter. By forming such projections and depressions, it is possible to suppress total reflection that occurs at the boundary face between the supporting substrate and the air, or the boundary face between the sealing material and the air. It should be noted that instead of directly forming projections and depressions on the supporting substrate or the sealing material, it is acceptable to laminate a film on the surface of which projections and depressions are formed onto the supporting substrate or the sealing material. When laminating the film via a predetermined adhesive layer, it is preferable that the absolute value of difference in refractive index between the adhesive layer and two members (the film and the supporting substrate, or the film and the sealing material) that are laminated via this adhesive layer be equal to or smaller than 0.2. By using such an adhesive layer and a film, it is possible to suppress the reflection of light at the film or the adhesive layer.

Hereinafter, a more specific structure of each component of the organic EL element and a production method thereof will be described.

As described above, the organic EL element can include predetermined layers in addition to the pair of electrodes.
Examples of an organic layer 10 that is formed between the electrode (anode) 2 and the electrode (cathode) 5 formed on the supporting substrate 6 include the following structures.

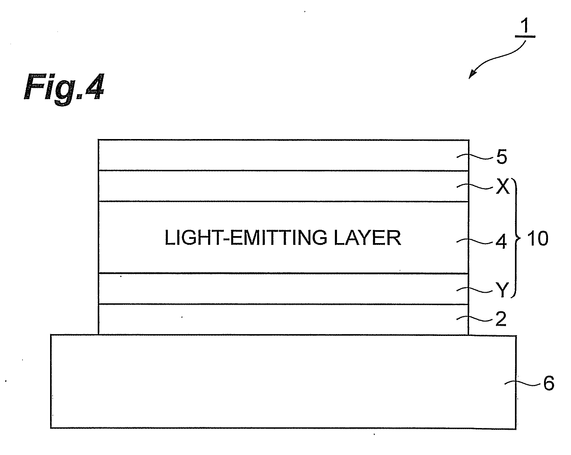

A structure of the organic EL element, as depicted in FIG. 4, may be a structure in which an organic layer Y lies between the electrode (anode) 2 and the light-emitting layer 4 and also an organic layer X lies between the electrode (cathode) 5 and the light-emitting layer 4. In this case, the periodic structure depicted in FIG. 2 is formed on either one or both of the organic layer X and the organic layer Y

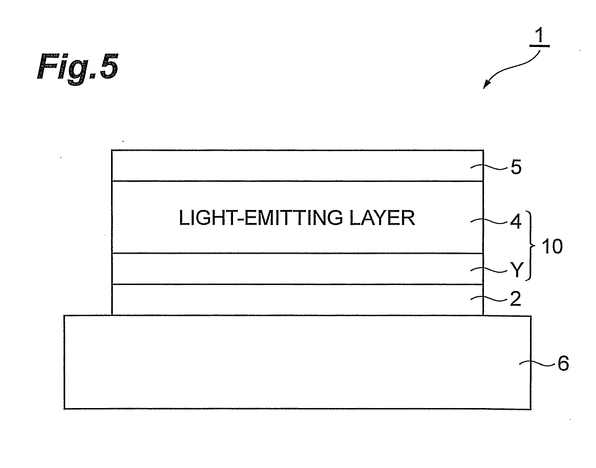

A structure of the organic EL element, as depicted in FIG. 5, may be a structure in which the organic layer Y lies between the electrode (anode) 2 and the light-emitting layer 4 and the electrode 5 is formed directly on the light-emitting layer 4. In this case, the periodic structure depicted in FIG. 2 is formed on the organic layer Y

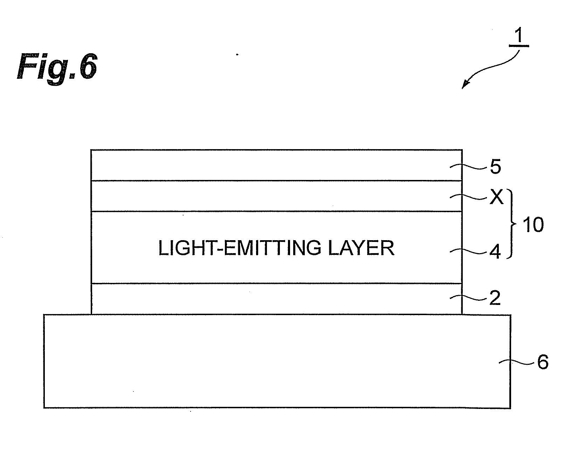

A structure of the organic EL element, as depicted in FIG. 6, may be a structure in which the organic layer X lies between the electrode (cathode) 5 and the light-emitting layer 4 and the light-emitting layer 4 is directly in contact with the electrode 2. In this case, the periodic structure depicted in FIG. 2 is formed on the organic layer X.

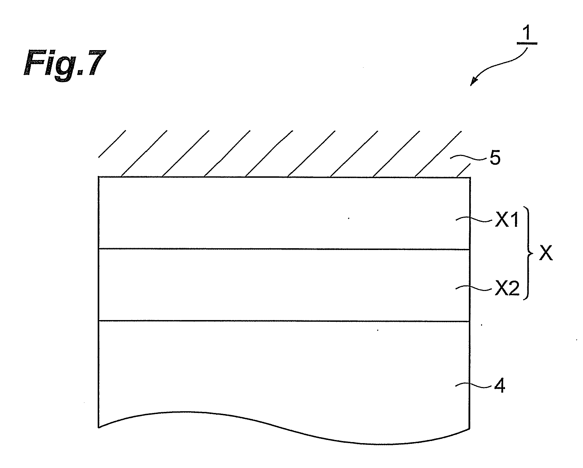

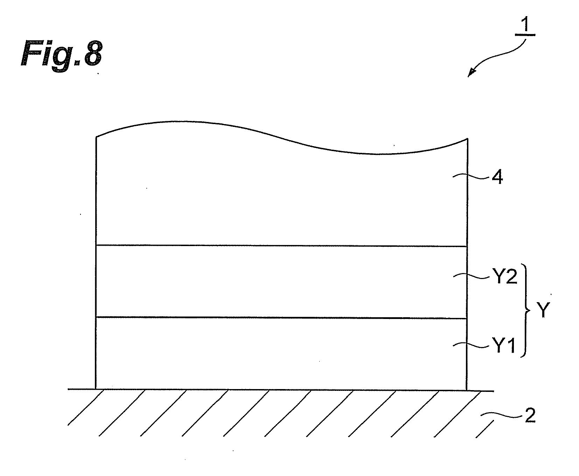

The organic layer X, as depicted in FIG. 7, may consists of two or more types of organic layers X1 and X2, and the organic layer Y, as depicted in FIG. 8, may consists of two or more types of organic layers Y1 and Y2. In this case, the periodic structure depicted in FIG. 2 is formed on one or more layers selected from the organic layers X1, X2, Y1, and Y2.

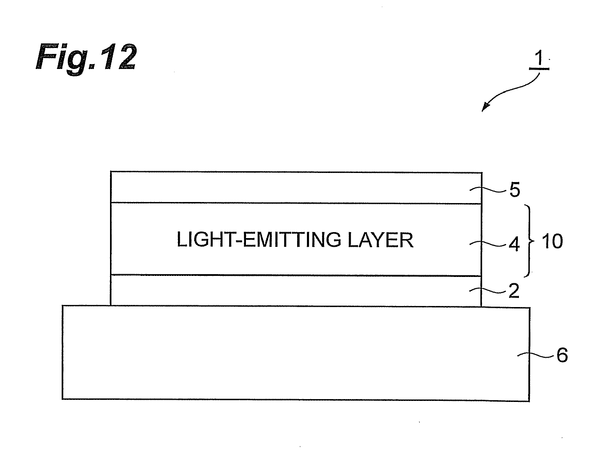

As a structure of the organic EL element, as depicted in FIG. 12, only the light-emitting layer 4 is formed between the anode 2 and the cathode 5, and in this case, the periodic structure depicted in FIG. 2 is formed in the light-emitting layer 4.

Examples of the layer X to be provided between the cathode 5 and the light-emitting layer 4 include an electron injection layer, an electron transport layer, a hole-blocking layer. As depicted in FIG. 7, in the case that both of the electron injection layer X1 and the electron transport layer X2 are provided between the cathode 5 and the light-emitting layer 4, the layer being in contact with the cathode 5 is referred to as the electron injection layer X1, and the layer except the electron injection layer X1 is referred to as the electron transport layer X2.

The electron injection layer has a function of improving efficiency of electron injection from the cathode. The electron transport layer has a function of improving the electron injection from the layer being in contact with the surface on the cathode side. The hole-blocking layer has a function of blocking hole transport. It should be noted that in the case that the electron injection layer and/or the electron transport layer has the function of blocking hole transport, these layers also serve as the hole-blocking layer in some cases.

When the hole-blocking layer has the function of blocking hole transport, by preparing an element for flowing only hole current, for example, it is possible to confirm the blocking effect by reduction of the current value.

Examples of the layer Y to be provided between the anode 2 and the light-emitting layer 4 include a hole injection layer, a hole transport layer, an electron-blocking layer. As depicted in FIG. 8, in the case that both of the hole injection layer Y1 and the hole transport layer Y2 are provided between the anode 2 and the light-emitting layer 4, the layer being in contact with the anode is referred to as the hole injection layer Y1, and the layer except the hole injection layer Y1 is referred to as the hole transport layer Y2.

The hole injection layer has a function of improving efficiency of hole injection from the anode. The hole transport layer has a function of improving the hole injection from the layer being in contact with the surface on the anode side. The electron-blocking layer has a function of blocking electron transport. It should be noted that in the case that the hole injection layer and/or the hole transport layer has the function of blocking electron transport, these layers also serve as the electron-blocking layer in some cases.

When the electron-blocking layer has the function of blocking electron transport, by preparing an element for flowing only electron current, it is possible to confirm the blocking effect by reduction of the current value.

It should be noted that, in some cases, the electron injection layer and the hole injection layer are generically referred to as a charge injection layer, and the electron transport layer and the hole transport layer are generically referred to as a charge transport layer.

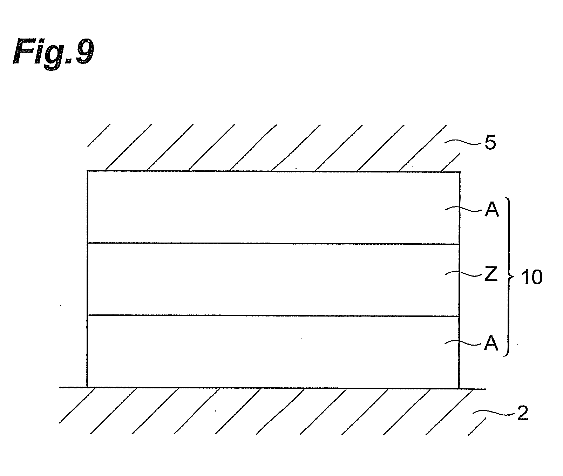

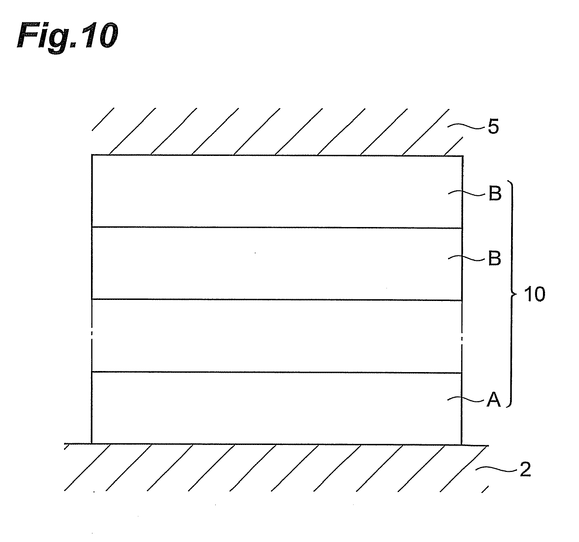

Examples of possible layer structures of the organic EL element of the present embodiment are listed below.
a) Anode 2 / Light-Emitting Layer 4 / Cathode 5 (see FIG. 12)
b) Anode 2 / Hole Injection Layer Y / Light-Emitting Layer 4 / Cathode 5 (see FIG. 5)
c) Anode 2 / Hole Injection Layer Y / Light-Emitting Layer 4 / Electron Injection Layer X / Cathode 5 (see FIG. 4)
d) Anode 2 / Hole Injection Layer Y / Light-Emitting Layer 4 / Electron Transport Layer X / Cathode 5 (see FIG. 4)
e) Anode 2 / Hole Injection Layer Y / Light-Emitting Layer 4 / Electron Transport Layer X2 / Electron Injection Layer X1 / Cathode 5 (see FIG. 4 and FIG. 7)
f) Anode 2 / Hole Transport Layer Y / Light-Emitting Layer 4 / Cathode 5 (see FIG. 5)
g) Anode 2 / Hole Transport Layer Y / Light-Emitting Layer 4 / Electron Injection Layer X / Cathode 5 (see FIG. 4)
h) Anode 2 / Hole Transport Layer Y / Light-Emitting Layer 4 / Electron Transport Layer X / Cathode 5 (see FIG. 4)
i) Anode 2 / Hole Transport Layer Y / Light-Emitting Layer 4 / Electron Transport Layer X2 / Electron Injection Layer X1 / Cathode 5 (see FIG. 4 and FIG. 7)
j) Anode 2 / Hole Injection Layer Y1 / Hole Transport Layer Y2 / Light-Emitting Layer 4 / Cathode 5 (see FIG. 5 and FIG. 8)
k) Anode 2 / Hole Injection Layer Y1 / Hole Transport Layer Y2 / Light-Emitting Layer 4 / Electron Injection Layer X / Cathode 5 (see FIG. 4 and FIG. 8)
l) Anode 2 / Hole Injection Layer Y1 / Hole Transport Layer Y2 / Light-Emitting Layer 4 / Electron Transport Layer X / Cathode 5 (see FIG. 4 and FIG. 8)
m) Anode 2 / Hole Injection Layer Y1 / Hole Transport Layer Y2 / Light-Emitting Layer 4 / Electron Transport Layer X2 / Electron Injection Layer X1 / Cathode 5 (see FIG. 4, FIG. 7, and FIG. 8)
n) Anode 2 / Light-Emitting Layer 4 / Electron Injection Layer X / Cathode 5 (see FIG. 6)
o) Anode 2 / Light-Emitting Layer 4 / Electron Transport Layer X / Cathode 5 (see FIG. 6)
p) Anode 2 / Light-Emitting Layer 4 / Electron Transport Layer X2 / Electron Injection Layer X1 / Cathode 5 (see FIG. 6 and FIG. 7)
   (Here, the mark "/" indicates that the respective layers sandwiching the mark "/" are laminated adjacent to each other. The same applies hereinafter.)
   The organic EL element of the present embodiment may have two or more light-emitting layers. In either one of the layer structures a) to p) listed above, when referring to a laminate held between the anode 2 and the cathode 5 as a "structural unit A", examples of a structure of the organic EL element having two light-emitting layers, as depicted in FIG. 9, include the layer structure indicated in q) below. It should be noted that the (structural unit A) indicated two times may be the same or may be different from each other.
q) anode 2/(structural unit A)/charge-generating layer Z/(structural unit A)/cathode 5
   In addition, when referring to the "(structural unit A)/charge-generating layer Z" as a "structural unit B", examples of a structure of the organic EL element having three or more light-emitting layers, as depicted in FIG. 10, include the layer structure indicated in r) below.
r) anode 2/(structural unit B) x/(structural unit A)/cathode 5
   where the mark "x" indicates an integer equal to or more than two, and (structural unit B) x indicates a laminate with x layers of structural unit B being laminated. Layer structures of a plurality of (structural unit B) may be the same or may be different.

Here, the charge-generating layer Z is a layer that generates a hole and an electron by applying an electric field. Examples of the charge-generating layer Z include a thin film made of, for example, vanadium oxide, indium tin oxide (ITO), molybdenum oxide, or the like.

In the embodiments described above, configurations in which both layers of the hole injection layer and the light-emitting layer, or only the hole injection layer has the periodic structure have been described, but in the structures of a) to r), it is acceptable to form the periodic structure on one predetermined layer or two or more predetermined layers that are arranged between the anode and the cathode.

### <Supporting Substrate>

As the supporting substrate, for example, glass, plastic, a polymer film, and a silicon plate, and also one with these plates being laminated are used. It should be noted that, in the bottom emission type organic EL element, a substrate having optically transparency is used, but in the top emission type organic EL element, it is acceptable to use an opaque substrate.

As the supporting substrate, one having high gas barrier properties is preferable, but in order to improve the gas barrier properties, it is acceptable to form an inorganic layer made of, for example, metal, metal oxide, metal nitride, metal carbide, metal oxynitride, or the like, laminated layers of the inorganic layer and the organic layer, an organic-inorganic hybrid layer, or the like on at least one surface of the supporting substrate.

### <Pair of Electrodes>

The pair of electrodes are configured with the anode and the cathode.

As the anode, a thin film of metal oxide, metal sulfide, metal, and the like is usable. As the anode, a thin film made of indium oxide, zinc oxide, tin oxide, ITO, indium zinc oxide (IZO), gold, silver, platinum, copper, or the like is used, and among these, a thin film made of ITO, IZO, or tin oxide is preferably used. Alternatively, as the anode, it is acceptable to use an organic transparent conductive film such as polyaniline or derivatives thereof and polythiophene or derivatives thereof.

As the cathode, one that has a small work function, facilitates electron injection into the light-emitting layer, and has high electric conductivity is preferable, and an alkali metal, an alkali earth metal, a transition metal, a metal of Group 13 of the periodic table, or the like is usable. As material for the cathode, used is a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the metals, an alloy of one or more of the metals and one or more of gold, silver, platinum, copper, manganese, titanium, cobalt, nickel, tungsten, and tin, graphite or a graphite interlayer compound, or the like. It should be noted that the cathode may be configured with a laminate with two or more layers laminated. Also, the electron injection layer described later may be used as the cathode in some cases.

As described above, an electrode having optical transparency is used for one of the pair of electrodes. For example, it is possible to use one with the above-mentioned metals laminated to the extent that visible light can penetrate, or a thin film made of ITO, IZO, or tin oxide as the electrode having optical transparency.

The film thicknesses of the anode and the cathode are appropriately set in view of required properties and simplicity of the process, and they are 10 nanometers to 10 micrometers, for example, preferably 20 nanometers to 1 micrometer, and more preferably 50 nanometers to 500 nanometers.

Examples of a production method for the anode and the cathode include a vacuum deposition method, a sputtering method, an ion plating method, a plating method, a method of performing thermocompression bonding of a metal thin film, and a lamination method.

### <Hole Injection Layer>

Examples of a hole injection material constituting the hole injection layer include a phenylamine-based material, a starburst type amine-based material a phthalocyanine-based material, oxides such as vanadium oxide, molybdenum oxide, ruthenium oxide, and aluminum oxide, amorphous carbon, polyaniline, and a polythiophene derivative. It is possible to form the hole injection layer, as described above, by applying ink containing the materials thus exemplified by a predetermined coating method, and further drying it.

Examples of a solvent for ink include, for example, chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, ester-based solvents such as ethyl acetate, butyl acetate, and ethyl cellosolve acetate, and water.

Examples of the predetermined coating method include a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method, and an inkjet printing method.

### <Hole Transport Layer>

Examples of a hole transport material constituting the hole transport layer include polyvinylcarbazole or derivatives thereof, polysilane or derivatives thereof, a polysiloxane derivative having aromatic amine at a side chain or a main chain, a pyrazoline derivative, an arylamine derivative, a stilbene derivative, a triphenyldiamine derivative, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

Among these hole transport materials, as the hole transport material, polymer hole transport materials such as polyvinylcarbazole or derivatives thereof, polysilane or derivatives thereof, a polysiloxane derivative having an aromatic amine compound group at a side chain or a main chain, polyaniline or derivatives thereof, polythiophene or derivatives thereof, polyarylamine or derivatives thereof, poly(p-phenylenevinylene) or derivatives thereof, and poly(2,5-thienylenevinylene) or derivatives thereof are preferable, and polyvinylcarbazole or derivatives thereof, polysilane or derivatives thereof, a polysiloxane derivative having aromatic amine at a side chain or a main chain, and the like are more preferable. In the case of using a low-molecular-weight hole transport material, it is preferable to use it dispersed into a polymer binder.

Examples of a method of forming a film of the hole transport layer include, in the case of the low-molecular-weight hole transport material, a method of forming a film from a mixed solution thereof with the polymer binder, and include, in the case of a polymer hole transfer material, a method of forming a film from a solution.

A solvent to be used in forming a film from a solution may be those capable of dissolving the hole transport material, and examples thereof include chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, and ester-based solvents such as ethyl acetate, butyl acetate, and ethyl cellosolve acetate.

As the polymer binder to be mixed, those that do not extremely inhibit charge transport are preferable, and those having weak visible light absorption are preferably used. Examples of the polymer binder include polycarbonate, polyacrylate, polymethylacrylate, polymethylmethacrylate, polystyrene, polyvinyl chloride, and polysiloxane.

The film thickness of the hole injection layer is, for example, 1 nanometer to 1 micrometer, preferably 2 nanometers to 500 nanometers, and more preferably 5 nanometers to 200 nanometers.

### <Light-Emitting Layer>

The light-emitting layer is configured to contain an organic substance emitting fluorescent and/or phosphorescent light, or the organic substance and a dopant. The dopant is added for the purpose of improving light emission efficiency or changing an emission wavelength, for example. The organic substance to be used for the light-emitting layer may be either a low-molecular-weight compound or a polymer compound. Examples of the light-emitting material constituting the light-emitting layer are enumerated below, for example. It should be noted that because a polymer compound generally has higher solubility in solvent, in the case of forming the light-emitting layer by the coating method, it is preferable that the light-emitting layer contain the polymer compound.

Examples of a dye-based light-emitting material include a cyclopendamine derivative, a tetraphenylbutadiene derivative, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a pelynone derivative, a perylene derivative, an oligothiophene derivative, an oxadiazole dimmer, and a pyrazoline dimmer.

Examples of a metal complex-based light-emitting material include a metal complex having a rare earth metal (e.g., Tb, Eu, or Dy), A1, Zn, Be, Ir, Pt, or the like as a central metal, and having oxadiazole, thiadiazole, phenylpyridine, phenylbenzoimidazole, a quinoline structure, or the like as a ligand, and examples thereof include an iridium complex, a metal complex such as platinum complex emitting light from a triplet excited state, an alumiquinolinol complex, a benzoquinolinol beryllium complex, a benzooxazole zinc complex, a benzothiazole zinc complex, an azomethyl zinc complex, a porphyrin zinc complex, and a phenanthroline europium complex.

Examples of the polymer-based light-emitting material include a polyparaphenylene vinylene derivative, a polythiophene derivative, a polyparaphenylene derivative, a polysilane derivative, a polyacetylene derivative, a polyfluorene derivative, and a polyvinylcarbazole derivative as well as those obtainable by polymerizing the dye-based light-emitting material and metal complex-based light-emitting material, and the like.

Among the above-mentioned light-emitting materials, examples of a material emitting blue light include a distyrylarylene derivative, an oxadiazole derivative, polymers thereof, a polyvinylcarbazole derivative, a polyparaphenylene derivative, and a polyfluorene derivative. Among them, a polyvinylcarbazole derivative, a polyparaphenylene derivative, a polyfluorene derivative, and the like that are polymer materials are preferable.

In addition, examples of a material emitting green light include a quinacridone derivative, a coumarin derivative, polymers thereof, a polyparaphenylene vinylene derivative, a polyfluorene derivative. Among them, a polyparaphenylene vinylene derivative, a polyfluorene derivative, and the like that are polymer materials are preferable.

In addition, examples of a material emitting red light include a coumarin derivative, a thiophene ring compound, polymers thereof, a polyparaphenylene vinylene derivative, a polythiophene derivative, and a polyfluorene derivative. Among them, a polyparaphenylene vinylene derivative, a polythiophene derivative, a polyfluorene derivative, and the like that are polymer materials are preferable.

In addition, as a material emitting white light, it is acceptable to use one prepared by mixing materials emitting each of blue, green, and red lights, or a polymer prepared by polymerizing components constituting materials emitting light in each color as monomers. Alternatively, it is acceptable to laminate light-emitting layers formed by using respective materials emitting light in each color to fabricate an element that emits white light as a whole.

Examples of the dopant material include a perylene derivative, a coumarin derivative, a rubrene derivative, a quinacridone derivative, a squarylium derivative, a porphyrin derivative, a styryl-based dye, a tetracene derivative, a pyrazolone derivative, decacyclene, and phenoxazone. It should be noted that a thickness of the light-emitting layer is usually about 2 nanometers to 2000 nanometers.

Examples of a method of forming a film of the light-emitting layer containing the organic substance include a method of applying a solution containing the light-emitting material on a surface of a substrate, a vacuum deposition method, and a lamination method. Specific examples of a solvent to be used for film formation from a solution include those that are used as the solvent for dissolving the hole injection material in forming a film of the hole injection layer from the solution.

Examples of the method of applying the solution containing the light-emitting material include the above-described coating methods.

### <Electron Transport Layer>

Examples of an electron transport material constituting the electron transport layer include an oxadiazole derivative, anthraquino-dimethane or derivatives thereof, benzoquinone or derivatives thereof, naphthoquinone or derivatives thereof, anthraquinone or derivatives thereof, tetracyanoanthraquino-dimethane or derivatives thereof, a fluorenone derivative, diphenyldicyanoethylene or derivatives thereof, a diphenoquinone derivative, 8-hydroxyquinoline or metal complexes of derivatives thereof, polyquinoline or derivatives thereof, polyquinoxaline or derivatives thereof, and polyfluorene or derivatives thereof.

Among them, as the electron transport material, an oxadiazole derivative, benzoquinone or derivatives thereof, anthraquinone or derivatives thereof, 8-hydroxyquinoline or metal complexes of derivatives thereof, polyquinoline or derivatives thereof, polyquinoxaline or derivatives thereof, and polyfluorene or derivatives thereof are preferable, and 2-(4-biphenylyl)-5-(4-t-butylphenyl)-1,3,4-oxadiazole, benzoquinone, anthraquinone, tris(8-quinolinol)aluminum, and polyquinoline are more preferable.

Examples of a method of forming a film of the electron transport layer, in the case of the low-molecular-weight electron transport material, include a method of forming a film from a powder by vacuum deposition and a method of forming a film from a solution or a molten state, and in the case of the polymer electron transport material, include a method of forming a film from a solution or from a molten state. In forming a film from a solution or molten state, it is acceptable to further use a polymer binder in combination. Examples of the method of forming a film of the electron transport layer from a solution include the same methods as the above-described methods of forming a film of the hole transport layer from a solution.

An optimum value of the film thickness of the electron transport layer varies depending on the material to be used and could be selected so as to attain an appropriate driving voltage and light emission efficiency. The electron transport layer needs to have a thickness so that generation of a pin hole is at least prevented, and it is not preferable that an excessively large thickness entails a high driving voltage of the element. Therefore, the film thickness of the hole injection layer is, for example, 1 nanometer to 1 micrometer, preferably 2 nanometers to 500 nanometers, and more preferably 5 nanometers to 200 nanometers.

### <Electron Injection Layer>

Examples of an electron injection material constituting the electron injection layer include, depending on the type of the light-emitting layer, an alkali metal, an alkali earth metal, an alloy containing one or more of the metals, oxides, halides, and carbonates of the metals, and mixtures of these substances. Examples of the alkali metal or oxides, halides, and carbonates thereof include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of the alkali earth metal or oxides, halides, and carbonates thereof include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be a laminate that is prepared by laminating two or more layers. Specific examples of the laminate include LiF/Ca. The electron injection layer is formed by a vapor deposition method, a sputtering method, a printing method, or the like. The film thickness of the electron injection layer is preferable to be about 1 nanometers to 1 micrometer.

### <Sealing material>

As the sealing material, for example, an inorganic layer made of a metal, a metal oxide, a metal nitride, a metal carbide, a metal oxynitride, or the like, a layer formed by laminating the inorganic layer and an organic layer, an organic-inorganic hybrid layer are usable. As the inorganic layer, one that is stable in the air is preferable, and specific examples thereof include thin film layers of silica, alumina, titania, indium oxide, tin oxide, titanium oxide, zinc oxide, indium tin oxide, aluminum nitride, silicon nitride, silicon carbide, silicon oxynitride, and combinations thereof, and preferable one is the thin film layer formed from aluminum nitride, silicon nitride, or silicon oxynitride, and further preferable one is the thin film of silicon oxynitride.

The organic EL element described above can be preferably used for a curved or plane lighting device, a sheet-like light source used for a light source of a scanner, for example, and a display device.

Examples of the display device including the organic EL element include a segment display and a dot matrix display. Examples of the dot matrix display include an active matrix display and a passive matrix display. The organic EL element, in the active matrix display and the passive matrix display, is used as a light-emitting element constituting each pixel. In addition, the organic EL element, in the segment display, is used as a light-emitting element constituting each segment or a backlight, and in a liquid crystal display, is used as a backlight.

It should be noted that if using a flexible supporting substrate, it is possible to use the organic EL element as a flexible lighting device or display device.

### Example

### (Preparation of Hole Injection Layer Coating Solution)

By adding γ-glycidoxypropylmethoxysilane (TSL8350 manufactured by Toshiba Silicone Co., Ltd.) as a silane coupling agent to an aqueous dispersion (AI4083 manufactured by H.C. Starck-V TECH Ltd.) of poly(3,4-ethylenedioxythiophene)/polystyrenesulfonic acid (PEDOT/PSS), prepare a hole injection layer coating solution. Set the concentration of the silane coupling agent in solid content in the hole injection layer coating solution to 5 mass%.

### <Fabrication of Organic EL Element>

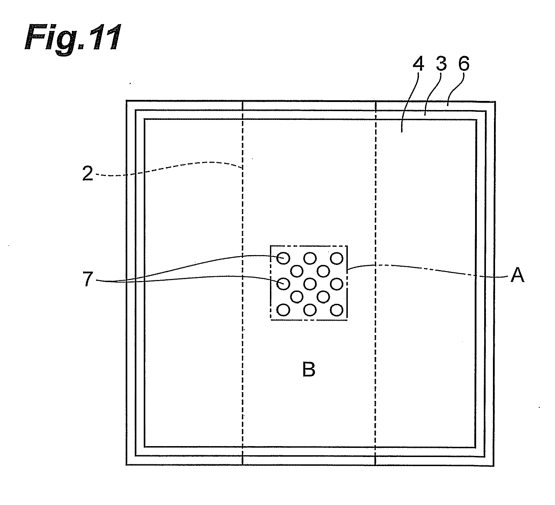

To begin with, as depicted in FIG. 11, in the center of a glass substrate (supporting substrate 6) of 5 cm×5 cm in a planar view, prepare a substrate on which an ITO thin film (electrode 2) of 2 cm×5 cm is formed as an anode. Ultrasonically clean this substrate with acetone, isopropyl alcohol, and ultrapure water, and dry it with nitrogen blowing. Perform UV ozonation on this substrate for 20 minutes, and on the glass substrate on which the ITO thin film is formed, apply the hole injection layer coating solution by spin coating to form a plane layer (hole injection layer 3) of 80 nanometers in film thickness. Furthermore, dry it at 150°C for 10 minutes on a hot plate. Next, via a reticle, perform 1/4 reduced projection exposure with light from a KrF excimer laser (wavelength 248 nanometers) on the plane layer. Subsequently, immerse the plane layer in ultrapure water for 30 seconds to develop it. By this process, a plurality of cylindrical holes of 150 nanometers in diameter and 80 nanometers in depth (holes 7 having cylindrical surfaces on the inside) are periodically formed on the plane layer 3. The holes 7 are formed within an area (A) of 1 cm×1 cm on the ITO thin film in a planar view. In other words, the periodic structure is formed only within the area (A) in a planar view. The cylindrical holes (holes having cylindrical surfaces on the inside) are formed so that the distance between central axes of the holes 7 adjacent to each other is 300 nanometers and the crossing angle between the vertical stripes 8 and the horizontal stripes 9 is 60°.

Next, prepare a xylene solution in which the concentration of a green-light-emitting material (Lumation GP1300 manufactured by Sumation Co., Ltd.) is 1.2 mass%. Apply this solution onto the hole injection layer 3 by spin coating. Remove part of the light-emitting material that is applied on an unnecessary area such as a part not lying on the electrode 2, and further perform heat processing on the hot plate in the nitrogen atmosphere at 130°C for 60 minutes to form the light-emitting layer 4 of 80 nanometers in thickness.

Next, bring the substrate on which the light-emitting layer 4 is formed into a vacuum deposition device, and sequentially deposit Ba and A1 of 5 nanometers and 10 nanometers in thickness respectively to form the cathode (electrode 5, see FIG. 3).

Next, prepare a sealing glass. Apply a photo-curing sealing agent to the periphery of this sealing glass with a dispenser, and laminate the substrate on which the organic EL element is formed and the sealing glass in the nitrogen atmosphere, and further perform sealing by curing the photo-curing sealing agent with ultraviolet rays to fabricate the organic EL element.

### <Evaluation>

As described above, in the hole injection layer, the area (A) on which the periodic structure is formed exist, and the periodic structure is not formed in an area (B) that is the residual excluding the area (A). In other words, in the area (B), a plane hole injection layer and a plane light-emitting layer are laminated.

When applying a voltage to the organic EL element to emit light, it is possible to visually confirm that the area (A) is brighter than the area (B). It was verified that the surfaces of the electrodes facing each other in this manner are flat, stable light emission is obtained by forming the periodic structure on the organic layer, the light extracting efficiency improves, and the light emission efficiency improves.

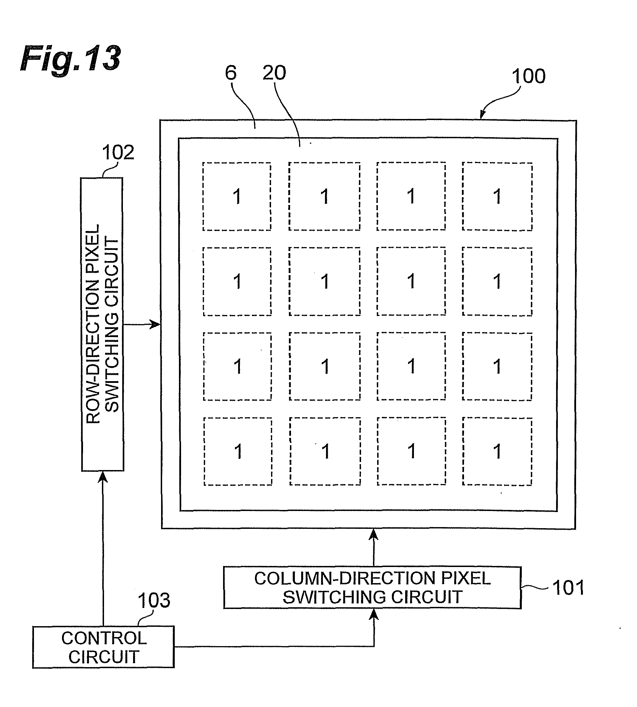

FIG. 13 is a diagram illustrating a display device including the organic EL element.
An organic EL display panel 100 is configured by forming a plurality of organic EL elements 1 on the same supporting substrate 6 and coating the whole area of the organic EL elements 1 with a sealing material 20. The organic EL elements 1 are pixels in the display device, and are arranged two-dimensionally.

Each pixel column constituted by the individual organic EL elements 1 aligned in the column direction, by controlling a column-direction pixel switching circuit 101 by a control circuit 103, connects either one of the anode and the cathode belonging to this pixel column to first electric potential (e.g., ground potential).
Each pixel row constituted by the individual organic EL elements 1 aligned in the row direction, by controlling a row-direction pixel switching circuit 102 by the control circuit 103, connects the other of the anode and the cathode belonging to this pixel row to second electric potential (e.g., bias potential).

When a bias voltage is applied to the anodes and the cathodes of the organic EL elements 1, the organic EL elements 1 emit light, and when a bias voltage is not applied, the organic EL elements turn off. Therefore, by instructions from the control circuit 103, it is possible to make pixels positioned in the specified addresses.

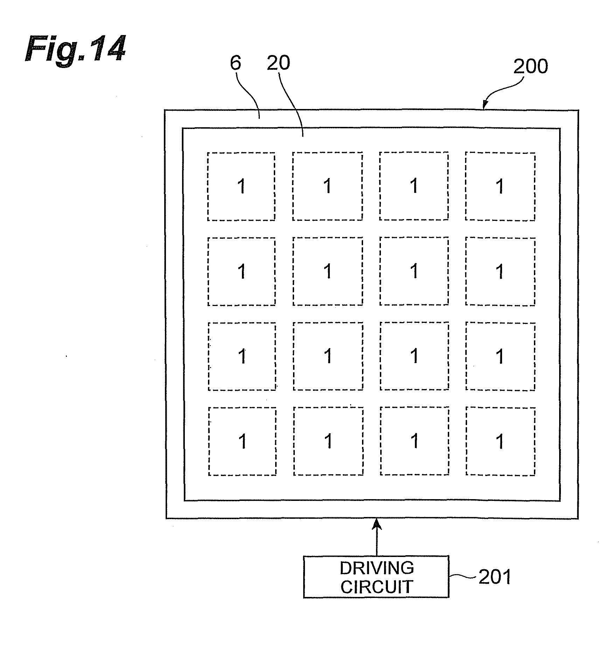

FIG. 14 is a diagram illustrating a lighting device including the organic EL element.

An organic EL display panel 200 is configured by forming a plurality of organic EL elements 1 on the same supporting substrate 6 and coating the whole area of the organic EL elements 1 with the sealing material 20. The organic EL elements 1 are point light sources in the lighting device, and are arranged two-dimensionally. When applying a bias voltage between the anodes and the cathodes of the organic EL elements from a driving circuit 201, all of the organic EL elements 1 emit light and function as the lighting device. It should be noted that in the above description, the lighting device is assumed to include the organic EL elements 1, but it may include a single organic EL element 1 having a wide area. In addition, it should be appreciated that the organic EL element 1 adopted in the display device and the lighting device described above are assumed to be the organic EL element 11.

### Reference Signs List

- 1, 11: organic EL element
- 2: one electrode
- 3: hole injection layer
- 4: light-emitting layer
- 5: other electrode
- 6: supporting substrate
- 7: depression
- 8: vertical stripe
- 9: horizontal stripe

## Claims

1. An organic electroluminescent element comprising:
a pair of electrodes;
one or more organic layers provided between the electrodes; and
a light-emitting layer as the one or more organic layers, wherein
surfaces of the pair of electrodes facing each other are flat,
at least one organic layer of the one or more organic layers has a periodic structure that makes a traveling direction of light, traveling in a direction generally perpendicular to a thickness direction of the light-emitting layer, inclined to the thickness direction, and
the periodic structure has a periodic configuration that is arranged with a two-dimensional period in a plane that is perpendicular to the thickness direction of the light-emitting layer.

2. The organic electroluminescent element according to claim 1, wherein both main surfaces of the light-emitting layer are flat and plane.

3. The organic electroluminescent element according to claim 2, wherein an organic layer that is arranged in contact with one of the main surfaces of the light-emitting layer out of the one or more organic layers has the periodic structure, and voids are formed in the organic layer having the periodic structure.

4. The organic electroluminescent element according to claim 1, wherein the light-emitting layer has the periodic structure.

5. A display device comprising the organic electroluminescent element according to claim 1.

6. A lighting device comprising the organic electroluminescent element according to claim 1.

7. A production method of an organic electroluminescent element that includes a pair of electrodes and one or more organic layers provided between the electrodes and includes a light-emitting layer as the one or more organic layers, the production method comprising:
a step of forming one of the pair of electrodes;
a step of forming one or more organic layers; and
a step of forming another one of the pair of electrodes, wherein
in the step of forming one or more organic layers, by forming a plane layer as the organic layer and further forming a periodic configuration arranged with a two-dimensional period in a plane that is perpendicular to a thickness direction of the light-emitting layer on the plane layer, a periodic structure is formed that makes a traveling direction of light, traveling in a direction generally perpendicular to the thickness direction of the light-emitting layer, inclined to the thickness direction.

8. The production method of an organic electroluminescent element according to claim 7, wherein a method of forming a two-dimensional periodic structure on the plane layer is an imprint method.

9. The production method of an organic electroluminescent element according to claim 7, wherein a method of forming a two-dimensional periodic structure on the plane layer is a photolithography method.
